(19) Europäisches Patentamt
European Patent Office
Office européen des brevets

(11) **EP 2 843 430 B1**

(12) **EUROPEAN PATENT SPECIFICATION**

(45) Date of publication and mention
of the grant of the patent:
**05.12.2018 Bulletin 2018/49**

(21) Application number: **14180789.1**

(22) Date of filing: **13.08.2014**

(51) Int Cl.:
*G01R 31/34* (2006.01)          *H02M 1/32* (2007.01)
*G01R 31/02* (2006.01)          *G01R 31/04* (2006.01)
*H02M 7/48* (2007.01)          *H02P 6/12* (2006.01)
*H02M 7/5387* (2007.01)

(54) **Method of detecting state of power cable in inverter system**

Verfahren zur Detektion des Stromkabelzustands in einem Wechselrichtersystem

Procédé de détection d'état de câble de puissance dans un système d'inverseur

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **02.09.2013 KR 20130104839**

(43) Date of publication of application:
**04.03.2015 Bulletin 2015/10**

(73) Proprietor: **LSIS Co., Ltd.**
**Dongan-gu, Anyang-si**
**Gyeonggi-do 431-080 (KR)**

(72) Inventor: **Kang, Yong Jin**
**Anyang-si, Gyeonggi-do 431-080 (KR)**

(74) Representative: **K&L Gates LLP**
**Karolinen Karree**
**Karlstraße 12**
**80333 München (DE)**

(56) References cited:
**EP-A1- 1 873 002          EP-A2- 2 003 041**
**JP-A- 2011 072 078          US-A- 5 689 170**
**US-A1- 2006 186 914**

**Description**

**BACKGROUND**

The present disclosure relates to an inverter system, and more particularly, to a method of detecting the state of a power cable in an inverter system that may detect the disconnection of a high-voltage cable connecting an inverter to a motor.

An inverter system that is a motor controller used for an environment-friendly vehicle is an electric/electronic sub assembly (ESA) or electric/electronic component that plays a role of converting high-voltage direct current (DC) power into alternating current (AC) or DC power for controlling a motor. Thus, the inverter system is an important component that belongs to the electric motor of a vehicle.

As such, a permanent magnet type motor is applied to the environment-friendly vehicle as a driving unit. The motor applied to the environment-friendly vehicle as the driving unit is driven by a phase current that is transmitted through a first high-voltage power cable from an inverter that converts a DC voltage into a three-phase voltage by a pulse width modulation (PWM) signal of a controller.

Also, the inverter converts a DC link voltage transmitted through a second high-voltage power cable into a three-phase voltage by the opening/closing of a main relay.

Thus, if any one of the first power cable connecting the inverter to the motor and the second power cable connecting the high-voltage battery to the inverter is separated, the motor does not smoothly operate and a high voltage/ current is introduced into a system, so a vital limitation that damages the entire inverter system occurs.

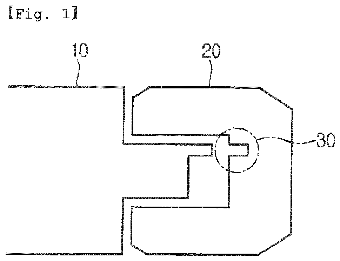

Fig. 1 represents a device for detecting separation of a power cable in an inverter system according to a related art.

Referring to Fig. 1, the device for detecting the separation of the power cable according to the related art includes a power cable 10, a connector 20, and a sensor 30 that is formed between the power cable 10 and the connector 20 and transmits a signal according to whether the power cable 10 is separated from the connector 20.

The sensor 30 is connected to (a contact portion) between the power cable 10 and the connector 20, and transmits a digital signal to a controller according to whether the power cable 10 is connected to the connector 20.

That is, a sensor that checks whether the power cable 10 is separated is typically installed on the power cable 10 or the connector 20 as separate hardware, and whether the power cable 10 is separated is checked in real time by using the digital signal output from the sensor.

However, since the device for detecting the separation of the power cable as described above detects by using hardware whether the power cable is separated, there are constraints of money and space.

Also, the device for detecting the separation of the power cable as described above is more likely to perform malfunction due to an external factor such as vibration and this works as a factor that threatens driver's safety.

Recently, a method of detecting the disconnection of the power cable by using software is being provided.

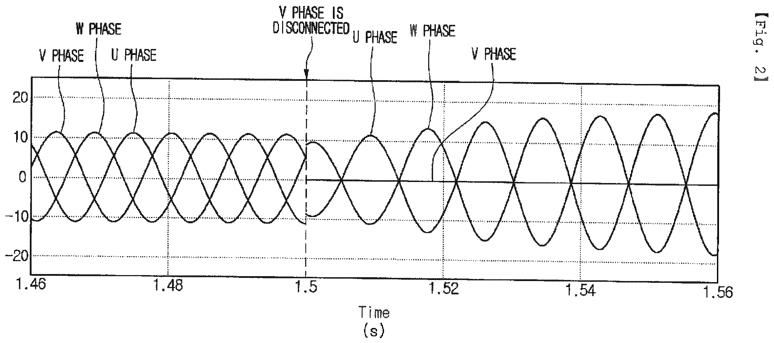

Fig. 2 represents a change in current when a general power cable has disconnection.

Referring to Fig. 2, when a power cable is disconnected, a current flow varies, in which case, when two or more phases are disconnected, three phase currents all become zeroes, and when only one phase is disconnected, only the current of a disconnected phase (v phase in Fig. 2) becomes zero. Thus, disconnection is determined according to whether there is a big difference between the magnitude of a current for a certain time and an instruction value or the magnitude of the current is zero.

US 2006/186914 A1 discloses a method for detecting a loss of a phase in a multiphase rotating field machine, the method comprising providing a first electrical current into the machine windings to cause the current vector to assume a first current vector position, sensing a first current in at least one selected phase winding of the machine, comparing the sensed first current in the at least one selected phase winding with a first calculated current for the selected phase winding, and detecting that a first phase fault has occurred if the first calculated and sensed first currents differ by more than a predetermined value.

JP2011072078 A discloses a control unit which calculates the phase of current injected into the motor as a current injection phase based on a rotor phase [theta] of the motor. Also, the control unit injects a high-frequency current, which is not less than a prescribed frequency under the condition of out of synchronization of the motor, to the motor based on the current injection phase at the time of a motor stop. Also, the control unit determines an open phase of the motor based on a current value of each phase of the motor after the injection of the high-frequency current.

EP 2 003 041 A2 discloses, in a motor controller, in the case that occurrence of a failure of electric current flow is detected in any phase of a motor, a phase electric current command value changing in accordance with a secant curve or a cosecant curve with an asymptotic line at a predetermined rotation angle corresponding to the phase in which the failure of electric current flow has occurred is calculated. The calculated phase electric current command value is limited in such a manner as to become within a predetermined range. In the case that a rotation angle of the motor exists in a range in which the phase electric current command value is limited, the execution of an anomaly detection of a control system utilizing an electric current deviation of a d/q coordinate system is inhibited.

EP 1 873 002 A1 discloses providing an electric vehicle control device which is capable of detecting even a state in which only one phase of one induction motor is disconnected in a system where a plurality of induction motors are connected in parallel with each other and driven by one vector-controlled inverter device. The electric vehicle control device according to the present invention includes a torque calculation unit for calculating the torque of the induction motor on the basis of a q-axis current, a d-axis current, a q-axis voltage command, a d-axis voltage command, and an inverter angular frequency, which are obtained by a vector control unit, a torque variation width calculation unit that calculates the torque variation width from a maximum value and a minimum value of a torque calculation result in a predetermined time width on the basis of the torque calculation result, and a comparator that outputs a disconnection detection signal when the torque variation width exceeds the torque variation width reference value.

US 5 689 170 A discloses a PWM generation block which implements two-phase/three phase conversion of torque current and exciting current and, on the basis of the converted three-phase torque and exciting currents and a three-phase current for driving and controlling the drive motor, outputs a PWM signal. A torque current estimator receives the same three-phase current as that of the three-phase current input to the PWM generation block, and implement three-phase/two-phase conversion of a three-phase current, by using a phase angle output from the microcomputer to calculate and output estimation values of the torque and exciting currents. A first comparator compares the absolute value of amplitude and the phase angle of the motor primary current and the motor primary frequency which are respectively output from the microcomputer with those which are respectively output from a fail-safe control block. The first comparator outputs a fail-safe signal when it detects differences between the compared values. A second comparator compares the estimation values of the torque and exciting currents which are output from the torque estimator with the torque and exciting currents which are output from the fail-safe control block, respectively. The second comparator outputs a fail-safe signal when it detects differences between the signals compared thereby.

However, since the above-described method detects only the magnitude of a current, there is a chance of malfunction by a motor's speed and a sampling period.

## SUMMARY

The invention provides a method of detecting the states of power cables in an inverter system according to independent method claim 1. Further advantageous modifications are defined by the dependent claims. Embodiments provide a method of detecting the state of a power cable in an inverter system that may detect the state of the power cable by using the size of the space vector of a current in addition to the magnitude of the current.

Technical tasks to be achieved by presented embodiments are not limited to the above-mentioned technical tasks and other technical tasks not mentioned will be able to be clearly understood by a person skilled in the art from the following descriptions.

In one embodiment, a method of detecting the states of power cables in an inverter system supplying power generated from an inverter to a motor by using three phase power cables includes: calculating the location of a current space vector for a first period when the first period arrives; using the calculated location of the current space vector for the first period to calculate the predicted location of the current space vector for a second period; calculating the actual location of the current space vector for the second period when the second period arrives; comparing the calculated predicted location with the actual location; and detecting the states of the three phase power cables according to a comparison result.

The calculating of the location of the current space vector for the first period or the calculating of the actual location of the current space vector for the second period may include: obtaining three phase current values supplied to the motor for a corresponding period; using obtained three phase current values to calculate the d-axis current and q-axis current of a stator's coordinate system; and using the ratio of a calculated q-axis current to a calculated d-axis current and an arctangent function to calculate the location of the current space vector.

The calculating of the predicted location of the current space vector for the second period includes: obtaining the rotating speed of the motor; using the rotating speed of the motor to calculate the rotating speed of the current space vector; and may further include using the sampling time between the first period and the second period and the calculated rotating speed of the current space vector to calculate the predicted location of the current space vector for the second period.

The comparing of the calculated predicted location with the actual location includes determining whether the difference between the predicted location and the actual location is larger than a preset reference value.

The detecting of the states of the three phase power cables may include: checking three phase current values obtained for the second period when the difference between the predicted location and the actual location is larger than the preset reference value; and detecting that two or more of the three phase power cables are disconnected when checked three phase current values are all zeroes.

The detecting of the states of the three phase power cables includes: checking the actual location of the current space vector for the second period when the difference between the predicted location and the actual location is larger than the preset reference value; and determining which of the three-phase power cables is disconnected when checked three phase current values are all zeroes.

The determining of which of the three-phase power cables is disconnected may include: detecting that the u-phase power cable of the three-phase power cables is disconnected when the actual location of the current space vector for the second period is 90° or -90°; and detecting that the v-phase power cable of the three-phase power cables is disconnected when the actual location of the current space vector for the second period is - 30° or 150°; and detecting that the w-phase power cable of the three-phase power cables is disconnected when the actual location of the current space vector for the second period is 30° or -150°.

According to an embodiment, by detecting the state of the power cables connected to a motor by using the size of the space vector of the current in stead of the magnitude of the current, it is possible to remarkably decrease an detection error probability caused by detecting sizes for repetitive sampling operations, and by quickly detecting whether the power cables are disconnected, it is possible to prevent further serious accidents

The details of one or more embodiments are set forth in the accompanying drawings and the description below. Other features will be apparent from the description and drawings, and from the claims.

## BRIEF DESCRIPTION OF THE DRAWINGS

Fig. 1 represents a device for detecting separation of a power cable in an inverter system according to a related art.
Fig. 2 represents a change in current when a general power cable has disconnection.
Fig. 3 is a schematic diagram of an inverter system according to an embodiment.
Fig. 4 represents the space vector of three-phase currents according to an embodiment.
Fig. 5 represents the space vector of three-phase currents varying when a u-phase cable of power cables has disconnection according to an embodiment.
Fig. 6 represents the space vector of three-phase currents varying when a v-phase cable of power cables has disconnection according to an embodiment.
Fig. 7 represents the space vector of three-phase currents varying when a w-phase cable of power cables has disconnection according to an embodiment.
Fig. 8 is a flow chart of a method of detecting the state of a power cable in an inverter system according to an embodiment.

## DETAILED DESCRIPTION OF THE EMBODIMENTS

The followings only illustrate the principle of the present invention. Therefore, a person skilled in the art may invent various devices that implement the principle of the present invention and are included in the concepts and scope of the present invention, although being not clearly shown or described in the specification. Also, all conditional terms and embodiments enumerated in the specification are, in principle, intended only for the purpose of understanding the concepts of the present invention and thus it should be understood that the present invention is not limited to embodiments and state to be particularly enumerated.

Also, it should be understood that all detailed descriptions enumerating specific embodiments as well as the principle, view and embodiments of the present invention are intended to include their structural and functional equivalents. Also, such equivalents should be understood as including currently known equivalents as well as equivalents to be developed in future, namely, all elements invented to perform the same function irrespective of their structures.
The invention is defined by the independent claim. Further embodiments are defined in the dependent claims.

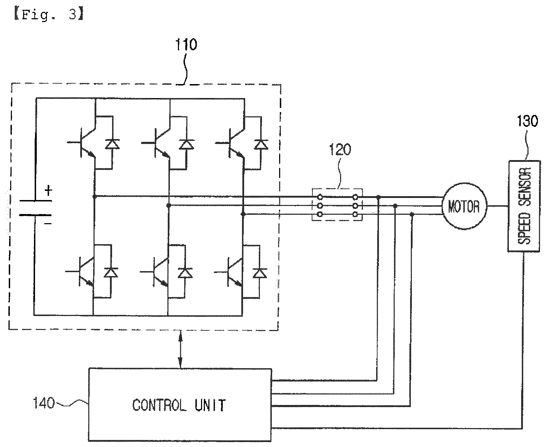

Fig. 3 is a schematic diagram of an inverter system

Referring to Fig. 3, an inverter system includes an inverter 110, three-phase power cables 120 supplying, to a motor, power output through the inverter 110, a sensor obtaining information on the operating state of the motor, and a control unit 140 controlling the operation of the inverter 110, detecting the disconnection of the three-phase cables 120 and stopping the operation of the inverter 110.

The inverter 110 is arranged in an electric vehicle and thus converts direct current (DC) power generated from a battery (not shown) arranged in the electric vehicle, into three-phase alternating current (AC) power.

In this case, the battery is a high-voltage battery and may be formed as a set of a plurality of unit cells.

In order to maintain a constant voltage, the plurality of unit cells may be managed by a battery management system (not shown) and the battery may emit a constant voltage by the control of the battery management system.

Also, power output by the discharge of the battery is transmitted to a capacitor in the inverter 110.

In this case, a relay is formed between the battery and the inverter 110, and the power supplied to the inverter 110 may be controlled by the operation of the relay.

That is, when the relay performs an ON operation, the power from the battery may be supplied to the inverter 110, and when the relay performs an OFF operation, a power supply to the inverter 110 may be cut off.

The inverter 110 converts DC power supplied to the battery into AC power and supplies the AC power to the motor.

In this case, the AC power converted by the inverter 110 may be three-phase power.

The inverter 110 includes the above-described capacitor and a plurality of insulated gate bipolar transistors (IGBTs) which perform pulse width modulation (PWM) switching according to a control signal applied from the control unit 140 to be described below, phase-convert power supplied from the battery and supply phase-converted power to the motor.

The motor may include a stator that does not rotate and is fixed, and a rotor that rotates. The motor receives AC power supplied through the inverter 110.

The motor may be e.g., a three-phase motor, and when voltage-variable/ frequency-variable AC power having each phase is applied to the coil of a stator having each phase, the rotating speed of the rotor varies depending on an applied frequency.

The motor may include an induction motor, a blushless DC (BLDC) motor, or a reluctance motor.

A driving gear (not shown) may be arranged on one side of the motor. The driving gear converts the rotational energy of the motor according to a gear ratio. The rotational energy output from the driving gear is transmitted to a front wheel and/or a rear wheel to enable an electric vehicle to move.

The power cables 120 are arranged between the inverter 110 and the motor. The power cables may be three-phase power cables and thus includes a u-phase cable, a v-phase cable, and a w-phase cable.

The sensor 130 obtains information on the driving state of the motor. In this case, Fig. 3 shows that the sensor 130 is a speed sensor. That is, the sensor 130 is arranged on one side of the motor and detects a rotating speed when the motor rotates.

In addition, when the rotating speed of the motor is detected, the sensor 130 transmits a detected rotating speed to the control unit 140.

Also, the sensor 130 may include a current sensor.

That is, the sensor 130 may include a current sensor that is arranged on each output line of the three-phase power cables 120 arranged between the inverter 110 and the motor and obtains three-phase currents.

Thus, the sensor 130 detects three phase current values (a u-phase current value, a v-phase current value, and a w-phase current value) supplied to the motor, and the rotating speed of the motor and transmits detected values to the control unit 140.

The control unit 140 controls the overall operations of the inverter 110.

For example, the control unit 140 uses the currents (three phase currents) supplied to the motor to calculate a value to operate the motor, and generates a switching signal for the control of the inverter (e.g., the switching control of the IGBT configuring the inverter) according to a calculated value.

Thus, the inverter 110 selectively performs ON/ OFF operation according to a switching signal generated through the control unit 140 and converts DC power supplied from the battery into AC power.

The control unit 140 uses three phase values transmitted through the sensor 130 and a rotating speed to detect the states of the power cables 120.

In addition, when the power cables 120 have a problem (e.g., disconnection, separation, or failure in connection), the control unit 140 may significantly affect the running of the electric vehicle because AC power converted through the inverter 110 is not supplied to the motor.

Thus, the control unit 140 detects whether the power cables 120 are disconnected, and when it is detected that the power cables 120 are disconnected, the control unit 140 cuts off an AC power supply to the motor.

The operation of detecting the disconnection of the power cables 120 performed by the control unit 140 is described below in detail.

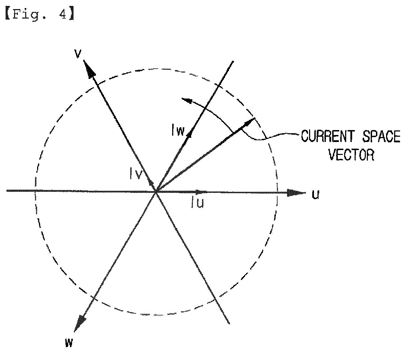

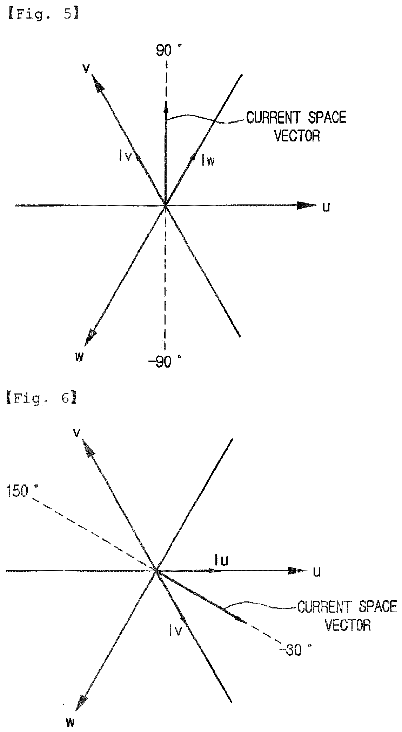

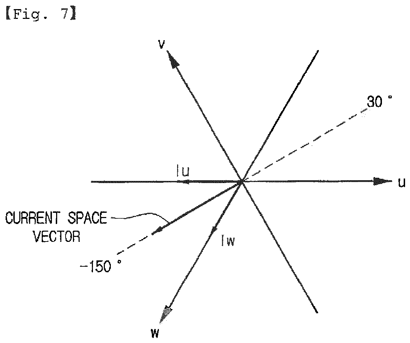

Fig. 4 represents the space vector of three-phase currents according to an embodiment, Fig. 5 represents the space vector of three-phase currents varying when a u-phase cable of power cables has disconnection according to an embodiment, Fig. 6 represents the space vector of three-phase currents varying when a v-phase cable of power cables has disconnection according to an embodiment, and Fig. 7 represents the space vector of three-phase currents varying when a w-phase cable of power cables has disconnection according to an embodiment.

The operation of detecting the disconnection of the power cables 120 performed by the control unit 140 is described with reference to Figs. 4 to 7.

Firstly, the relationship between a motor's speed and the speed of the space vector of a current is described.

When three phase currents are supplied to the motor through the power cables 120, the motor has torque and thus rotates.

In this case, when the motor is a synchronous motor, the rotating speed of the space vector of a current is the same as that of the motor, and when the motor is an asynchronous motor, the rotating speed of the space vector of the current is rather different from that of the motor.

Thus, when the rotating speed of the motor is known, it is possible to obtain the speed of the space vector of the current as well.

In this example, the space vector means a current vector in a 3D coordinate system.

That is, referring to Fig. 4, three phase windings that have a mechanical difference of 120° from one another are arranged at the motor, and three phase currents that have an electrical phase difference of 120° from one another flow on the three phase windings. Then, a magnetic field is formed by the three phase currents flowing, and the magnetic field is referred to as a space vector.

In this case, when normal three phase currents continue to flow, the space vector of the currents rotates.

However, when the three phase currents abnormally flow, the space vector of the currents does not rotate but varies to alternately appear on specific locations (that may be referred to as angles).

In other words, when it is assumed that the location of a current space vector obtained in Nth sampling is as shown in Fig. 4, the location of a N+lth current space vector when normal three phase currents flow rotates in an arrow direction in Fig. 4. In this case, the rotating speed of the space vector is affected by the rotating speed of the motor. For example, when the location of an Nth current space vector is 20° and the rotating speed of the motor is A, the location of the N+lth period current space vector rotates in the arrow direction by reflecting the time difference between the Nth period and the N+lth period and the rotating speed of the motor.

However, when the three phase currents abnormally flow (i.e., the power cables are disconnected), the rotation of the current space vector corresponding to a reflected angle is not performed. Thus, in a normal case, the location of the current space vector for the current period and the location of the current space vector for the next period have a certain gap according to the speed of the motor and a sampling time, but in an abnormal case, there is no association between the location of the current space vector for the current period and the location of the current space vector for the next period.

Thus, the control unit 140 calculates the location of the current space vector for the current period, and predicts where the current space vector for the next period is located, according to the location of the current space vector for a calculated current period. A prediction method may performed by using a sampling time and the speed of the motor.

Related descriptions are provided below in detail.

Firstly, the control unit 140 uses three phase values obtained through the sensor 130 to calculate the d-axis current and q-axis current of a stator coordinate system.

A method of calculating the d-axis current id and the q-axis current iq is as follows.

In order to calculate the d-axis current and the q-axis current, a vector idq is first found.

The vector idq may be calculated by Equation 1 below:

<Equation 1>

$$i_{dq} = i_d + ji_q = \frac{2}{3}(i_a + a \cdot i_b + a^2 \cdot i_c)$$

$$a = 1\angle 120^o = -\frac{1}{2} + j\frac{\sqrt{3}}{2}$$ .

Thus, the d-axis current id and the q-axis current iq may be found from the vector idq by Equation 2 below:

<Equation 2>

$$i_d = \mathrm{Re}\left[\frac{2}{3}(i_a + a \cdot i_b + a^2 \cdot i_c)\right]$$

$$i_q = \mathrm{Im}\left[\frac{2}{3}(i_a + a \cdot i_b + a^2 \cdot i_c)\right].$$

That is, by Equations 1 and 2, it is possible to calculate each of the d-axis current and q-axis current of the stator coordinate system from obtained three phase currents Ia, Ib and Ic.

Also, when the d-axis current and the q-axis current are calculated, it is possible to calculate the location of the current space vector by using the calculated d-axis current and q-axis current.

In other words, the location of the current space vector may be calculated by using the ratio of the q-axis current value of the stator coordinate system to its d-axis current value and an arctangent function.

The location of the current space vector may be calculated by Equation 3 below:

<Equation 3>

$$\theta = \tan^{-1}\left(\frac{i_q}{i_d}\right).$$

Based on Equations 1 to 3 above, the control unit 140 calculates the location of the current space vector every certain period N, N+1, or N+2

In this example, the location of the current space vector for the Nth period may be as follows:

$$\theta = \tan^{-1}\left(\frac{i_q[N]}{i_d[N]}\right).$$

Also, the location of the current space vector for the N+Ith period may be as follows:

$$\theta = \tan^{-1}\left(\frac{i_q[N+1]}{i_d[N+1]}\right).$$

In this case, the location of the current space vector varies through rotation according to the speed of the motor.

Thus, when the location of the current space vector for the current period is known, it is possible to predict the location of the current space vector for the next period based on a sampling time (the time difference between the N+Ith period and the Nth period).

That is, the control unit 140 may calculate the rotating speed of the current space vector according to the speed of the motor. The rotating speed of the current space vector may be calculated according to the type of the motor, and as described above, when the motor is the synchronous motor, the rotating speed of the current space vector is the same as the speed of the motor, and when the motor is the asynchronous motor, the rotating speed of the current space vector is rather different from the speed of the motor.

Thus, the control unit 140 may use the type of the motor and the speed of the motor to calculate the rotating speed of the current space vector.

Accordingly, the control unit 140 may use the location of the current space vector for the current period N, and the rotating speed of the current space vector for the current period N obtained from a rotor's speed (speed of the motor) to predict the location of the current space vector for the next period N+1.

The location of the current space vector for the next period may be predicted by Equation 4 below:

<Equation 4>

$$\theta = \tan^{-1}\left(\frac{i_q[N]}{i_d[N]}\right) + \omega_m \cdot T_s$$

where $\omega_m$ is the rotating speed of the current space vector and $T_s$ is a sampling time.

Then, when the next period N+1 arrives, the control unit 140 calculates the location of the current space vector according to a corresponding period.

The location of the current space vector for the corresponding period N+1 may be calculated by Equations 1 to 3 above.

Also, when the actual location of the current space vector for the next period is calculated, the control unit 140 compares the predicted location of the current space vector for the next period with the calculated actual location of the current space vector for the next period and checks whether there is a difference between the predicted location and the actual location.

In this case, since what the predicted location is the same as the actual location represents that three phase currents normally flow, the control unit 140 will be able to confirm that the power cables 120 are normally connected.

However, when there is a difference between the predicted location and the actual location, the control unit 140 checks whether the difference is within or outside an error bound. The error bound may be determined by calculating differences in location that may appear through various experiments, and may be designated as a reference value. For example, the error bound may be set to 10°.

Then, when the difference between the predicted location and the actual location is within the error bound, the control unit 140 determines that the power cables 120 are normally connected.

However, when the difference between the predicted location and the actual location is outside the error bound, the control unit 140 determines that the power cables 120 are abnormally connected (e.g., disconnected).

Then, the control unit 140 informs that the power cables 120 have an error, and cuts off a power supply to or from the inverter 110 correspondingly.

In this case, the control unit 140 uses the calculated actual location to check which of the power cables 120 has an error.

To this end, the control unit 140 checks three phase current values obtained through the sensor 130. In addition, when all the three phase current values checked are zeroes, the control unit 140 determines that two or more of the three phase cables have errors. That is, when two or more of the three phase cables are in a disconnected state, all the three phase current values become zeroes, in which case the control unit 140 may use the three phase current values to check whether two or more cables have errors.

Also, when all the three phase current values checked are not zeroes, the control unit 140 checks according to the change state of the actual location of the current space vector whether any one of the three phase power cables has an error.

In this case, when any one of the power cables is disconnected, only a current value corresponding to a disconnected phase becomes zero, in which case, there is a regular change in the location of the current space vector.

That is, in a state where three phase currents normally flow, the current space vector rotates to correspond to the rotating speed of the motor as shown in Fig. 4.

However, when any one of the three phase currents does not flow, the current space vector does not rotate and varies to alternately appear on two locations.

In other words, when the u-phase cable of the power cables is disconnected as shown in Fig. 5, the current space vector alternately appears on 90° and -90°.

Thus, the control unit 140 checks the location of the current space vector, and when the location of the current space vector varies to alternately appear on 90° and -90° as shown in Fig. 5, the control unit 140 determines that the u-phase cable of the power cables is disconnected.

Also, when the v-phase cable of the power cables is disconnected as shown in Fig. 6, the current space vector varies to alternately appear on -30° and 150°.

Thus, the control unit 140 checks the location of the current space vector, and when the location of the current space vector varies to alternately appear on -30° and 150° as shown in Fig. 6, the control unit 140 determines that the v-phase cable of the power cables is disconnected.

Also, when the w-phase cable of the power cables is disconnected as shown in Fig. 7, the current space vector varies to alternately appear on -150° and 30°.

Thus, the control unit 140 checks the location of the current space vector, and when the location of the current space vector varies to alternately appear on -150° and 30° as shown in Fig. 7, the control unit 140 determines that the w-phase cable of the power cables is disconnected.

As described above, according to an embodiment, by detecting the state of the power cables connected to a motor by using the size of the space vector of the current in stead of the magnitude of the current, it is possible to remarkably decrease an detection error probability caused by detecting sizes for repetitive sampling operations, and by quickly detecting whether the power cables are disconnected, it is possible to prevent further serious accidents.

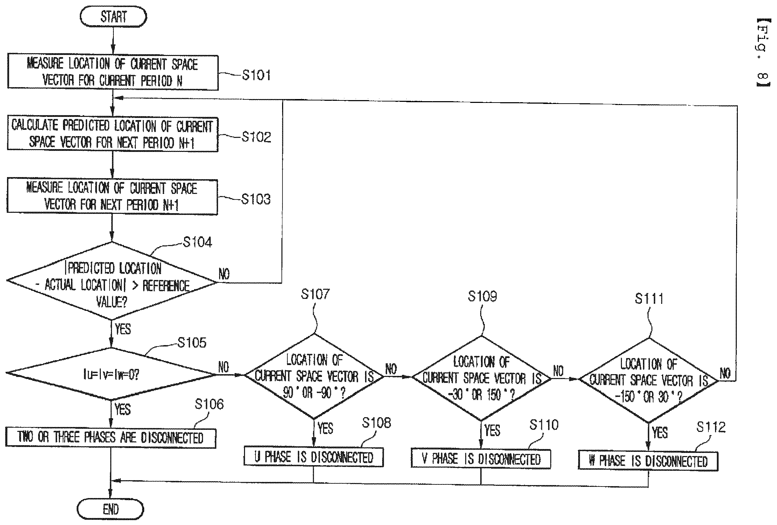

Fig. 8 is a flow chart of a method of detecting the states of power cables in an inverter system according to an embodiment.

Referring to Fig. 8, the control unit 140 first calculates the location of the current space vector for the current period (Nth period, hereinafter referred to as a 'first period') in step S101.

The current space vector may be calculated by Equations 1 to 3 above.

If the location of the current space vector for the first period is calculated, the control unit 140 calculates the predicted location of the current space vector for the next period (N+lth period, hereinafter referred to as a second period') in step S102.

That is, the control unit uses the speed of a motor to calculate the rotating speed of the current space vector, and uses a sampling time (the time difference between the first period and the second period) and the rotating speed of the current space vector to calculate the predicted location of the current space vector that will appear for the second period.

Then, when the second period arrives, the control unit 140 calculates the actual location of the current space vector for the second period in step S103.

When the actual location of the current space vector for the second period is calculated, the control unit 140 determines whether the difference between the predicted location and the actual location is larger than a preset reference value in step S104. That is, the control unit 140 determines whether the difference between the predicted location and the actual location is outside an error bound that is obtained through various experiments.

When the difference between the predicted location and the actual location is smaller than the preset reference value as a determination result in step S104, the control unit 140 considers that the power cables are normally connected, and returns to step S102.

However, when the difference between the predicted location and the actual location is larger than the preset reference value as a determination result in step S104, the control unit 140 senses that the power cables have errors, and checks which of the three phase power cables has an error in steps S105 to S112.

To this end, the control unit 140 first determines whether the three phase current values obtained to calculate the location of the current space vector are all zeroes in step S105.

Then, when all the three phase current values are zeroes as a determination result in step S105, it is determined that at least two the power cables are disconnected in step S106.

However, when all the three phase current values are not zeroes, the control unit 140 determines whether the location of the current space vector for the second period is 90°or -90° in step S107.

Then, when the location of the current space vector for the second period is 90°or -90° as a determination result in step S107, the control unit 140 detects that the u-phase cable of the power cables is disconnected in step S108.

Also, when the location of the current space vector for the second period is not 90°or -90° as a determination result in step S107, it is determined whether the location of the current space vector for the second period is -30° or 150° in step S109.

Then, when the location of the current space vector for the second period is -30°or 150° as a determination result in step S109, the control unit 140 detects that the v-phase cable of the power cables is disconnected in step S110.

Also, when the location of the current space vector for the second period is not -30°or 150° as a determination result in step S109, it is determined whether the location of the current space vector for the second period is 30° or -150° in step S111.

Then, when the location of the current space vector for the second period is 30°or -150° as a determination result in step S111, the control unit 140 detects that the w-phase cable of the power cables is disconnected in step S112.

According to an embodiment, by detecting the states of the power cables connected to a motor by using the size of the space vector of the current in stead of the magnitude of the current, it is possible to remarkably decrease an detection error probability caused by detecting sizes for repetitive sampling operations, and by quickly detecting whether the power cables are disconnected, it is possible to prevent further serious accidents.

**Claims**

1. A method of detecting the states of power cables in an inverter system supplying power generated from an inverter (110) to a motor by using three phase power cables (120), the method comprising:

   calculating a first location of a current space vector for a current period (S101) calculating a rotating speed of the current space vector by using a motor speed;
   predicting a second location of the current space vector for a second period (S102) based on the rotating speed and the first location;
   calculating a third location of the current space vector when the next period arrives (S103);
   comparing the second location with the third location (S104);
   checking the third location when the difference between the second location and the third location is larger than a preset reference value;
   determining that a u-phase cable of the three phase power cables is disconnected when the third location is alternately positioned on a first angle and a second angle (S107,S108);
   determining that a v-phase cable of the three phase power cables is disconnected when the third location is alternately positioned on a third angle and a fourth angle (S109,S110); and
   determining that a w-phase cable of the three phase power cables is disconnected when the third location is alternately positioned on a fifth angle and a sixth angle (S111,S112).

2. The method according to claim 1, wherein the calculating of the first location or the third location comprises:

   obtaining three phase current values supplied to the motor;
   using obtained three phase current values to calculate the d-axis current and q-axis current of a stator's coordinate system; and
   using the ratio of a calculated q-axis current to a calculated d-axis current and an arctangent function to calculate the first location or the third location of the current space vector.

3. The method of claim 1 or claim 2, wherein the predicting of the second location comprises:

   using the sampling time between the current period and the next period and the calculated rotating speed of the current space vector to calculate the second location of the current space vector for the next period.

4. The method of one claims 1 to 3, further comprising:

   checking three phase current values obtained for the next period when the difference between the second location and the third location is larger than the preset reference value; and
   detecting that two or more of the three phase power cables are disconnected when checked three phase current values are all zeroes.

5. The method of one claims 1 to 4, wherein the first angle between a u-axis and the current space vector is 90°, wherein the current space vector is based on current values of a v-axis and a w-axis;
   wherein the second angle between the u-axis and the current space vector is -90°, wherein the current space vector is based on current values of the v-axis and the w-axis;
   wherein the third angle between the u-axis and the current space vector is 150°, wherein the current space vector is based on current values of the v-axis and the u-axis;
   wherein the fourth angle between the u-axis and the current space vector is -30°, wherein the current space vector is based on current values of the v-axis and the u-axis;
   wherein the fifth angle between the u-axis and the current space vector is 30°, wherein the current space vector is based on current values of the u-axis and the w-axis; and
   wherein the sixth angle between the u-axis and the current space vector is -150°, wherein the current space vector is based on current values of the u-axis and the w-axis.

**Patentansprüche**

1. Verfahren zum Feststellen der Zustände von Stromkabeln in einem Wechselrichtersystem, das von einem Wechselrichter (110) erzeugte Energie unter Verwendung von dreiphasigen Stromkabeln (120) an einen Motor liefert, das Verfahren umfassend:

Berechnen einer ersten Position eines aktuellen Raumvektors für eine aktuelle Periode (S101)
Berechnen einer Drehgeschwindigkeit des aktuellen Raumvektors unter Verwendung einer Motordrehzahl;
Vorhersagen eines zweiten Ortes des aktuellen Raumvektors für eine zweite Periode (S102) basierend auf der Drehgeschwindigkeit und der ersten Position;
Berechnen einer dritten Stelle des aktuellen Raumvektors, wenn die nächste Periode ankommt (S103);
Vergleichen des zweiten Ortes mit dem dritten Ort (S104);
Prüfen des dritten Ortes, wenn die Differenz zwischen dem zweiten Ort und dem dritten Ort größer als ein voreingestellter Bezugswert ist;
Bestimmen, dass ein u-Phasenkabel der dreiphasigen Stromkabel getrennt ist, wenn der dritte Ort abwechselnd in einem ersten Winkel und einem zweiten Winkel (S107, S108) positioniert ist;
Bestimmen, dass ein v-Phasenkabel der dreiphasigen Stromkabel getrennt ist, wenn der dritte Ort abwechselnd in einem dritten Winkel und einem vierten Winkel (S109, S110) positioniert ist; und
Bestimmen, dass ein w-Phasenkabel der dreiphasigen Stromkabel getrennt ist, wenn der dritte Ort abwechselnd in einem fünften Winkel und einem sechsten Winkel (S111, S112) positioniert ist.

2. Verfahren nach Anspruch 1, wobei das Berechnen des ersten Ortes oder des dritten Ortes umfasst:

Erhalten von Dreiphasenstromwerten, die dem Motor zugeführt werden;
Verwenden der erhaltenen Dreiphasenstromwerte zum Berechnen des d-Achsen-Stroms und des q-Achsen-Stroms eines Stator-Koordinatensystems; und
Verwenden des Verhältnisses eines berechneten q-Achsen-Stroms zu einem berechneten d-Achsen-Strom und einer Arcustangens-Funktion, um den ersten Ort oder den dritten Ort des aktuellen Raumvektors zu berechnen.

3. Verfahren nach Anspruch 1 oder Anspruch 2, wobei das Vorhersagen des zweiten Ortes umfasst:
Verwenden der Abtastzeit zwischen der aktuellen Periode und der nächsten Periode und der berechneten Drehgeschwindigkeit des aktuellen Raumvektors, um den zweiten Ort des aktuellen Raumvektors für die nächste Periode zu berechnen.

4. Verfahren nach einem der Ansprüche 1 bis 3, ferner umfassend:

Prüfen von Dreiphasenstromwerten, die für die nächste Periode erhalten werden, wenn die Differenz zwischen der zweiten Position und der dritten Position größer als der voreingestellte Referenzwert ist; und
Erkennen, dass zwei oder mehr der dreiphasigen Stromkabel getrennt sind, wenn geprüft wird, dass die drei Phasenstromwerte alle Nullen sind.

5. Verfahren nach einem der Ansprüche 1 bis 4, wobei der erste Winkel zwischen einer U-Achse und dem aktuellen Raumvektor 90° beträgt, wobei der aktuelle Raumvektor auf aktuellen Werten einer v-Achse und einer w-Achse basiert;
wobei der zweite Winkel zwischen der u-Achse und dem aktuellen Raumvektor -90° beträgt, wobei der aktuelle Raumvektor auf aktuellen Werten der v-Achse und der w-Achse basiert;
wobei der dritte Winkel zwischen der u-Achse und dem aktuellen Raumvektor 150° beträgt, wobei der aktuelle Raumvektor auf aktuellen Werten der v-Achse und der u-Achse basiert;
wobei der vierte Winkel zwischen der u-Achse und dem aktuellen Raumvektor -30° beträgt, wobei der aktuelle Raumvektor auf aktuellen Werten der v-Achse und der u-Achse basiert;
wobei der fünfte Winkel zwischen der u-Achse und dem aktuellen Raumvektor 30° beträgt, wobei der aktuelle Raumvektor auf aktuellen Werten der u-Achse und der w-Achse basiert; und
wobei der sechste Winkel zwischen der u-Achse und dem aktuellen Raumvektor -150° beträgt, wobei der aktuelle Raumvektor auf aktuellen Werten der u-Achse und der w-Achse basiert.

**Revendications**

1. Procédé de détection des états de câbles d'alimentation dans un système d'onduleur alimentant un moteur, à partir d'un onduleur (110), à l'aide de câbles d'alimentation triphasés (120), le procédé comprenant :

le calcul d'un premier emplacement d'un vecteur spatial de courant pour une période en cours (S101) ;

le calcul d'une vitesse de rotation du vecteur spatial de courant à l'aide d'une vitesse de moteur ;

la prédiction d'un deuxième emplacement du vecteur spatial de courant pour une deuxième période en cours (S102) compte tenu de la vitesse de rotation et du premier emplacement ;

le calcul d'un troisième emplacement du vecteur spatial de courant à l'arrivée de la période suivante (S103) ;

la comparaison du deuxième emplacement au troisième emplacement (S104) ;

la vérification du troisième emplacement lorsque la différence entre le deuxième emplacement et le troisième emplacement est supérieure à une valeur de référence prédéfinie ;

la détermination du fait qu'un câble de phase U des câbles d'alimentation triphasés est déconnecté lorsque le troisième emplacement est alternativement positionné sur un premier angle et un deuxième angle (S107, S108) ;

la détermination du fait qu'un câble de phase V des câbles d'alimentation triphasés est déconnecté lorsque le troisième emplacement est alternativement positionné sur un troisième angle et un quatrième angle (S109, S110) ;

et

la détermination du fait qu'un câble de phase W des câbles d'alimentation triphasés est déconnecté lorsque le troisième emplacement est alternativement positionné sur un cinquième angle et un sixième angle (S111, S112).

2. Procédé selon la revendication 1, dans lequel le calcul du premier emplacement ou du troisième emplacement comprend :

l'obtention de trois valeurs de courant de phase fournies au moteur ;

l'utilisation des trois valeurs de courant de phase obtenues pour calculer le courant d'axe d et le courant d'axe q d'un système de coordonnées de stator ; et

l'utilisation du rapport entre un courant d'axe q calculé et un courant d'axe d calculé et d'une fonction arctangente pour calculer le premier emplacement ou le troisième emplacement du vecteur spatial de courant.

3. Procédé selon la revendication 1 ou la revendication 2, dans lequel la prédiction du deuxième emplacement comprend :

l'utilisation du temps d'échantillonnage entre la période en cours et la période suivante et de la vitesse de rotation calculée du vecteur spatial de courant pour calculer le deuxième emplacement du vecteur spatial de courant pour la période suivante.

4. Procédé selon l'une des revendications 1 à 3, comprenant en outre :

la vérification de valeurs de courant de phase obtenues pour la période suivante lorsque la différence entre le deuxième emplacement et le troisième emplacement est supérieure à la valeur de référence prédéfinie ; et

la détection du fait qu'au moins deux des câbles d'alimentation triphasés sont déconnectés lorsque les trois valeurs de courant de phase vérifiées sont toutes nulles.

5. Procédé selon l'une des revendications 1 à 4, dans lequel le premier angle entre un axe u et le vecteur spatial de courant est de 90°, le vecteur spatial de courant étant basé sur des valeurs de courant d'un axe v et d'un axe w ;

le deuxième angle entre l'axe u et le vecteur spatial de courant étant de -90°, le vecteur spatial de courant étant basé sur des valeurs de courant de l'axe v et de l'axe w ;

le troisième angle entre l'axe u et le vecteur spatial de courant étant de 150°, le vecteur spatial de courant étant basé sur des valeurs de courant de l'axe v et de l'axe u ;

le quatrième angle entre l'axe u et le vecteur spatial de courant étant de -30°, le vecteur spatial de courant étant basé sur des valeurs de courant de l'axe v et de l'axe u ;

le cinquième angle entre l'axe u et le vecteur spatial de courant étant de 30°, le vecteur spatial de courant étant basé sur des valeurs de courant de l'axe u et de l'axe w ; et

le sixième angle entre l'axe u et le vecteur spatial de courant étant de -150°, le vecteur spatial de courant étant basé sur des valeurs de courant de l'axe u et de l'axe w.

【Fig. 1】

【Fig. 2】

【Fig. 3】

【Fig. 4】

【Fig. 5】

【Fig. 6】

【Fig. 7】

【Fig. 8】

START

S101 — MEASURE LOCATION OF CURRENT SPACE VECTOR FOR CURRENT PERIOD N

S102 — CALCULATE PREDICTED LOCATION OF CURRENT SPACE VECTOR FOR NEXT PERIOD N+1

S103 — MEASURE LOCATION OF CURRENT SPACE VECTOR FOR NEXT PERIOD N+1

S104 — |PREDICTED LOCATION − ACTUAL LOCATION| > REFERENCE VALUE?
  NO → (return)
  YES ↓

S105 — |u|=|v|=|w|=0?
  NO ↓
  YES → TWO OR THREE PHASES ARE DISCONNECTED (S106) → END

S107 — LOCATION OF CURRENT SPACE VECTOR IS 90° OR −90°?
  YES → U PHASE IS DISCONNECTED (S108)
  NO ↓

S109 — LOCATION OF CURRENT SPACE VECTOR IS −30° OR 150°?
  YES → V PHASE IS DISCONNECTED (S110)
  NO ↓

S111 — LOCATION OF CURRENT SPACE VECTOR IS −150° OR 30°?
  YES → W PHASE IS DISCONNECTED (S112)
  NO → (return)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006186914 A1
- JP 2011072078 A
- EP 2003041 A2
- EP 1873002 A1
- US 5689170 A